(19) Europäisches Patentamt

European Patent Office

Office européen des brevets

(11) **EP 4 701 086 A1**

(12) **EUROPEAN PATENT APPLICATION**

(43) Date of publication:
**25.02.2026 Bulletin 2026/09**

(21) Application number: **25197332.7**

(22) Date of filing: **21.08.2025**

(51) International Patent Classification (IPC):
**H03M 1/16** $^{(2006.01)}$ **H03M 1/80** $^{(2006.01)}$

(52) Cooperative Patent Classification (CPC):
**H03M 1/164; H03M 1/806; H03M 1/808**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **22.08.2024 IN 202441063267**

(71) Applicant: **NXP B.V.**
**5656 AG Eindhoven (NL)**

(72) Inventor: **BALUNI, Alok**
**5656AG Eindhoven (NL)**

(74) Representative: **Hardingham, Christopher Mark**
**NXP Semiconductors**
**Intellectual Property Group**
**The Cattle Barn**
**Upper Ashfield Farm, Hoe Lane**
**Romsey, Hampshire S051 9NJ (GB)**

(54) **ADC CIRCUIT WITH DAC INCLUDING CAPACITANCE**

(57) An ADC circuit includes an ADC that converts an input analog signal to a digital signal. The ADC circuit includes a filter circuit that receives the analog input signal and provides a filtered signal to a combiner circuit. The ADC circuit includes a DAC that converts the digital signal back to an analog signal that is provided to a combiner circuit. The DAC includes one or more capacitive paths with capacitors between the input of the DAC and the output of the DAC.

FIG. 5

EP 4 701 086 A1

**Description**

**BACKGROUND OF THE INVENTION**

**Field of the Invention**

This invention relates to an analog to digital circuit including a digital to analog converter with capacitance.

**Background**

Some analog to digital converter (ADC) circuits such as continuous timed pipelined ADC circuits include a digital to analog converter (DAC) for converting a converted digital value back to an analog value.

**BRIEF DESCRIPTION OF THE DRAWINGS**

The present invention may be better understood, and its numerous objects, features, and advantages made apparent to those skilled in the art by referencing the accompanying drawings.

Figure 1 is a circuit diagram of a prior art ADC circuit.
Figure 2 is a more detailed circuit diagram of a prior art ADC circuit.
Figure 3 is a circuit diagram of portions of a prior art ADC circuit.
Figure 4 is a circuit diagram of an ADC circuit according to at least one embodiment of the present invention.
Figure 5 is a more detailed circuit diagram of an ADC circuit according to at least one embodiment of the present invention.
Figure 6 is a circuit diagram of an ADC circuit according to at least one embodiment of the present invention.
Figure 7 is a more detailed circuit diagram of an ADC circuit according to at least one embodiment of the present invention.

The use of the same reference symbols in different drawings indicates identical items unless otherwise noted. The Figures are not necessarily drawn to scale.

**DETAILED DESCRIPTION**

The following sets forth a detailed description of a mode for carrying out the invention. The description is intended to be illustrative of the invention and should not be taken to be limiting.

As described here, an ADC circuit includes an ADC that converts an input analog signal to a digital signal. The ADC circuit includes a filter circuit that receives the analog input signal and provides a filtered signal to a combiner circuit. The ADC circuit includes a DAC that converts the digital signal back to an analog signal that is provided to a combiner circuit. The DAC includes one or more capacitive paths with capacitors between the input of the DAC and the output of the DAC.

In some embodiments, implementing capacitance in a DAC of an ADC circuit may provide an ADC circuit with a flat-delay profile, a higher gain, and a larger useful bandwidth. Furthermore, such a feature may allow the ADC circuit to be implemented with amplifier configurations that consume less power. Accordingly, embodiments of such a circuit may be beneficial in high frequency applications.

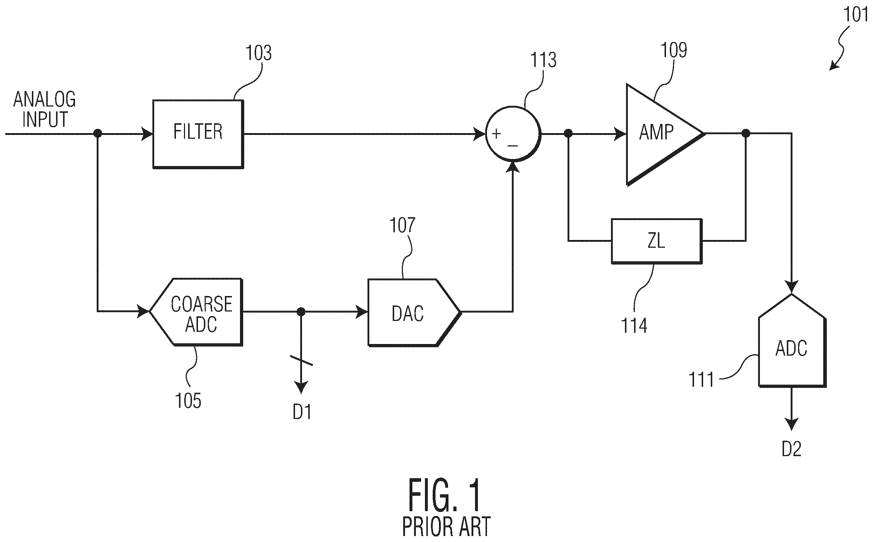

Figure 1 is a circuit diagram of a prior art continuous timed pipelined ADC circuit 101. Circuit 101 includes an analog input for receiving an analog signal that is provided to a coarse ADC 105. ADC 105 generates a digital signal (D1) that is a digital representation of the analog signal. In the example shown, D1 is a multi-bit, digital signal. ADC circuit 101 includes a residual DAC 107 that converts the digital signal D1 back to an analog signal and provides the digital signal to a combiner circuit 113. Circuit 101 also includes a filter 103 that provides a delay to the analog signal at its output to provide a filtered analog signal to combiner circuit 113. The delay of filter 103 is designed to match the combined delay of ADC 105 and DAC 107 in providing the reconstructed analog signal to combiner circuit 113.

Combiner circuit 113 subtracts the output of DAC 107 from the output of filter 103 and provides the resultant signal to amplifier 109. The resultant signal represents the quantized error between the analog input and D1. Amplifier 109 is configured in a transimpedance amplifier configuration with impedance circuit 114 in a feedback configuration with amplifier 109. The output of amplifier 109 represents the quantized error between the analog input and D1. The output of amplifier 109 is provided to ADC 111 to generate a digital signal D2 that is a digital representation of the quantization error of ADC circuit 101. D2 can be combined with D1 to provide a more accurate digital representation of the analog signal received at the analog input.

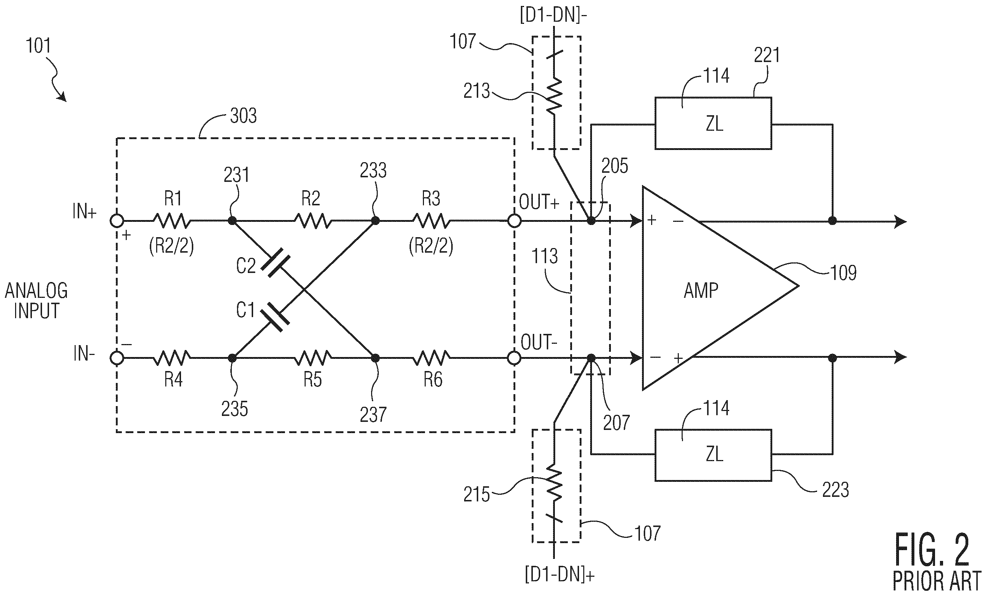

Figure 2 is a more detailed circuit diagram of portions of ADC circuit 101. In Figure 2, the analog input is a differential input that includes two input terminals (IN+, IN-). Filter 103 includes a resistive path that includes resistors R1-R3 located between the non inverting input terminal IN+ and the non inverting output terminal (OUT+) of filter 103. Filter 103 also includes another resistive path that includes resistors R4-R6 located between the inverting input terminal IN- and the inverting output terminal (OUT-) of filter 103. OUT+ is connected to the non inverting node 205 of combiner circuit 113 and OUT- is connected to the inverting node 207 of combiner circuit 113. Filter 103 includes a capacitor C2 connected between node 231 and node 237 and a capacitor C1 connected between node 235 and node 233.

The digital signal D1 is a multi-bit differential signal with inverting bit components [D1-DN]-, where each inverting bit component passes through a resistive circuit of resistive circuits 213 of DAC 107 coupled to non inverting node 205. Signal D1 also includes non inverting bit components [D1-DN]+, where each non inverting bit component passes through a resistive circuit of resistive circuits 215 of DAC 107 coupled to non inverting node 205.

Node 205 is connected to the non inverting input of amplifier 109 and node 207 is connected to the inverting input of amplifier 109. Impedance 221 of impedance circuit 114 is connected between the non inverting input and the inverting output of amplifier 109. Impedance 223 of impedance circuit 114 is connected between the inverting input and non inverting output of amplifier 109.

The RC delay network of filter 103 is based on the RC lattice structure which is designed for current mode summation. This necessitates that amplifier 109 be in a transimpedance amplifier configuration to provide for a large gain and wide unity gain bandwidth, and have a large slewing ability. The voltages of the analog input and of the DAC 107 output are converted to currents. The currents of the delayed input analog signal are subtracted from the currents of the DAC 107 and the resulting residue current produces a voltage drop proportional to the impedance ZL (221 and 223) of the impedance circuit 114.

It is desirable that filter 103 provide a constant delay across the entire bandwidth of the analog signal to minimize signal leakage into amplifier 109. However, when using the transimpedance amplifier configuration of Figures 1 and 2, to achieve a nearly flat delay profile, the maximum allowed frequency of the analog signal has to be less than one-third of the sampling rate of the analog signal. Furthermore, the loop gain of such a configuration is not constant across the entire signal bandwidth especially considering a choice of ZL (e.g., a capacitance in shunt with resistance) for first order low pass filtering of images in the reconstructed signal from the DAC 107. Accordingly, the unity gain bandwidth frequency of amplifier 109 is required to be rather large (e.g., 25 times larger) with respect to the signal bandwidth even for modest gains (e.g., G=2). The unity gain bandwidth requirement becomes more stringent as the gain is increased. This issue is further aggravated by loop gain reduction from parasitic input capacitance loading at the input of amplifier 109.

Furthermore, a transimpedance amplifier sinks currents from the analog input as well as switching currents from the DAC. Consequently, a good slewing ability of amplifier 109 is needed, which increases power dissipation. Because of the high unity gain bandwidth requirements and the high slewing requirements, implementing a transimpedance amplifier can be challenging, especially for high frequency applications.

Instead of utilizing a transimpedance configuration, residue voltage can be generated with a circuit having a passive summation configuration. With some passive summation configurations, the required unity gain bandwidth with respect to the signal bandwidth is much smaller (e.g., a factor of 4 times at a gain of 2) than with a transimpedance amplifier configuration. Accordingly, such a configuration would be beneficial for high frequency applications. However, passive summation configurations suffer from inherent attenuation of the residue signal by at least a factor of two which requires compensation. With some passive summation configurations for residue voltage generation, there is an inherent attenuation at the combining circuit (e.g., at least a factor of 0.5). This attenuation factor increases as the frequency increases due to the capacitive components of the RC lattice of the delay filter. Accordingly, the maximum utilizable bandwidth of such configurations is less than desirable especially with larger signal bandwidths (e.g., 3 GHz and greater).

Another issue with some passive summation configurations is that the attenuation of both the filter and DAC paths are frequency dependent, which reduces the effective bandwidth of voltage residue regeneration. This affects the unity gain bandwidth as well the DAC's sampled pulse response which sets the gain of each stage of an ADC circuit.

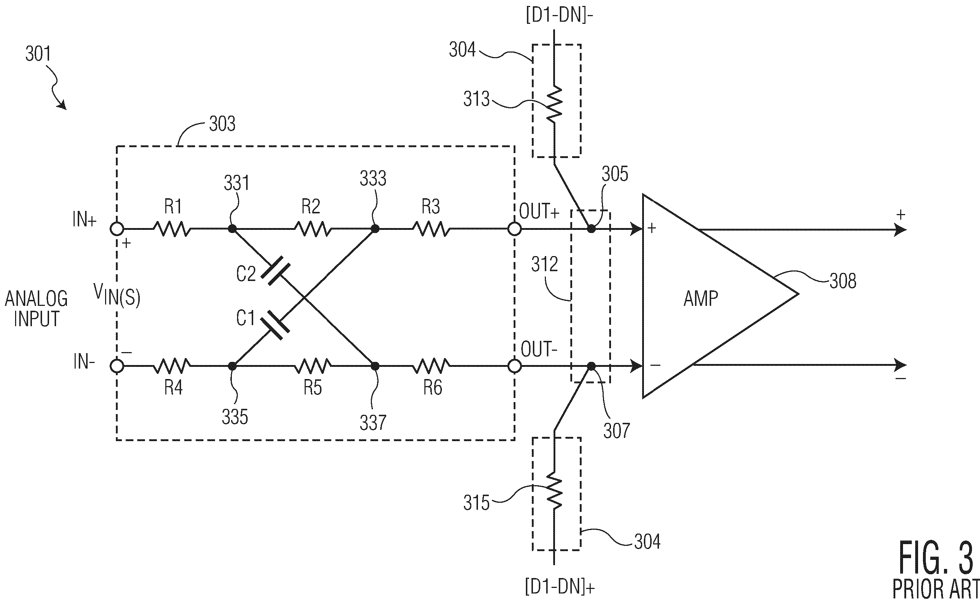

Figure 3 is a circuit diagram of a prior art ADC circuit 301 that includes a filter 303, DAC 304, combiner circuit 312 and amplifier 308 implemented in a passive summation configuration. In Figure 3, the analog input is a differential input that includes two input terminals (IN+, IN-). Filter 303 includes a resistive path that includes resistors R1-R3 located between the non inverting input terminal IN+ and the non inverting output terminal (OUT+) of filter 303. Filter 303 also includes another resistive path that includes resistors R4-R6 located between the inverting input terminal IN- and the inverting output terminal (OUT-) of filter 303. OUT+ is connected to the non inverting node 305 of combiner circuit 323 and OUT- is connected to the inverting node 307 of combiner circuit 312. Filter 303 includes a capacitor C2 connected between node 331 and node 337 and a capacitor C1 connected between node 335 and node 333.

The digital signal D1 is a multi-bit differential signal with inverting bit components [D1-DN]-, where each inverting bit component passes through a resistive circuit of resistive circuits 313 of DAC 304 that is coupled to non inverting node 305. Signal D1 also includes non inverting bit components [D1-DN]+, where each non inverting bit component passes through a resistive circuit of resistive circuits 315 of DAC 304 that is coupled to inverting node 307 of combiner circuit 312.

Node 305 is connected to the non inverting input of amplifier 308 and node 307 is connected to the inverting input of amplifier 308.

The transfer function at combiner circuit 312 is given as:

$$\text{EQ. 1 } \boldsymbol{TF(s) = 0.5 \frac{1-0.5sRC}{1+sRC} VIN(s) - 0.5 \frac{1+0.5sRC}{1+sRC} VD1(s)}$$

where R is the total series resistance of resistors R1-R3 and the total resistance of resistors R4-R6. R is also the total resistance of resistive circuits 313 configured in parallel and the total resistance of resistive circuit 315 configured in parallel. C is the capacitance of capacitor C1 and of capacitor C2. VD1 is the effective differential voltage of the DAC 304 represented as (D1+D2+....DN)/N. The resistance of resistors R2 and R5 is ½ R and the resistance of resistors R1, R3, R4, and R6 is ¼ R. The letter 's' represents Laplace transform.

As shown in Equation 1 above, there is a frequency dependent attenuation for both the filter path (

$$\boldsymbol{0.5 \frac{1-0.5sRC}{1+sRC}}$$

) and the DAC path (

$$\boldsymbol{0.5 \frac{1+0.5sRC}{1+sRC}}$$

). The frequency dependent attenuation of both paths reduces the effective bandwidth of circuit 301. Accordingly, such a configuration is less than desirable, especially for high frequency applications.

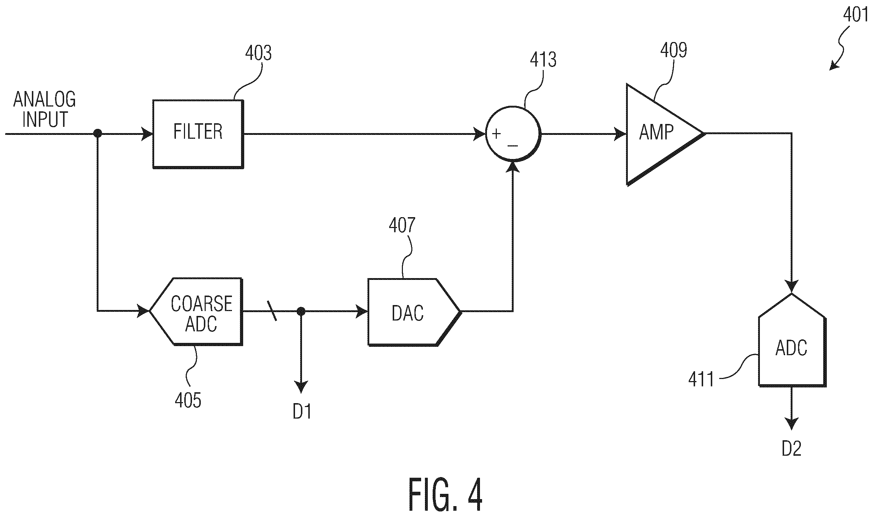

Figure 4 is a circuit diagram of an ADC circuit 401. In the embodiment of Figure 1, ADC circuit 401 is a continuous-time pipelined ADC. Circuit 401 includes an analog input to receive an analog signal. Circuit 401 includes a coarse ADC 405 that converts the analog signal to a digital representation D1 of the analog signal. Circuit 401 includes a DAC 407 that converts D1 back to an analog signal. Circuit 401 includes filter 403 that provides a filtered signal with a delay at its output. The delay of filter 403 is designed to match the combined delay of ADC 405 and DAC 407. The output of filter 403 is connected to combiner circuit 413. The analog output of DAC 407 is subtracted from the output signal of filter 403 at combiner circuit 413. That output of combiner circuit 413 is provided to amplifier 409. In the embodiment of Figure 4, filter 403, DAC 407, combiner circuit 413, and amplifier 409 are arranged in a passive summation configuration. The output of amplifier 409 represents the quantizing error in signal D1 with respect to the analog signal received at the analog input. The output of amplifier 409 is provided to ADC 411, which provides a digital signal D2 that is a digital representation of the quantizing error in signal D1. D2 is combined with D1 to provide a more accurate digital representation of the analog signal received at the analog input.

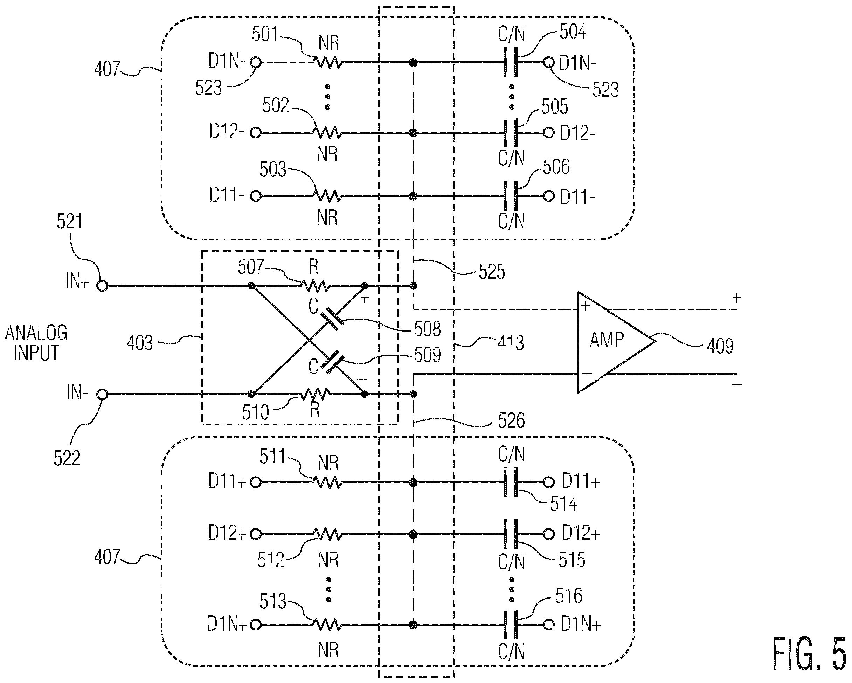

Figure 5 is a more detailed circuit diagram of the filter 403, DAC 407, combining circuit 413, and amplifier 409 according to some embodiments of the present invention. In the embodiment of Figure 5, the analog signal received at the analog input is a differential signal. The analog input includes differential input terminals 521 and 522.

Filter 403 implements an RC ladder network that includes a resistive path with a resistor 507 between input terminal 521 and node 525 of combiner circuit 413 and a resistive path with a resistor 510 between input terminal 522 and node 526 of combiner circuit 413. The output terminals of filter 403 are at its connection to nodes 525 and 526. Filter 403 also includes a capacitor path between input terminal 521 and node 526 that includes a capacitor 509. Filter 403 also includes another capacitor path between input terminal 522 and node 525 that includes capacitor 508. In the embodiment shown, resistors 507 and 510 have a resistance value of R and capacitors 508 and 509 have a capacitance value of C.

In the embodiment of Figure 5, digital signal D1 is a multi-bit, differential digital signal that includes non inverting signal bit components D11+ through D1N+ and inverting signal bit components D11- through D1N-. N is an integer of the number of signal bit components of the inverting component (D11- through D1N-) and of the non inverting component (D11+ through D1N+) of signal D1. Each signal line of the signal lines conveying the signal bit components (D11- through D1N- and D11+ through D1N+) of signal D1 is connected to an input terminal of DAC 407 where Figure 5 shows signal bit component D1N-connected to input terminal 523.

DAC 407 includes a set of resistors 501-503 and a set of capacitors 504-506. Each resistor of resistors 501-503 is located in resistive path between an input terminal of DAC 407 (e.g., terminal 523) that receives an inverting signal bit component (D11- through D1N-) and non inverting combiner circuit node 525. Each capacitor of capacitors 504-506 is located in a capacitive path between an input terminal of DAC 407 (e.g., terminal 523) and non inverting combiner circuit node 525. DAC 407 includes an another set of resistors 511-513 and an another set of capacitors 514-516. Each resistor of resistors 511-513 is located in resistive path between an input terminal of DAC 407 that receives a non inverting signal bit component (D11+ through D1N+) and inverting combiner node 526. Each capacitor of capacitors 514-516 is located in capacitive path between an input terminal of DAC 407 that receives a non inverting signal bit component (D11+ through D1N+) and inverting combiner node 526. In the embodiment of Figure 5, the output of DAC 407 includes its connections to the nodes of combiner circuit 413.

As shown in Figure 5, the non inverting input of amplifier 409 is connected to non inverting combiner node 525 and the inverting input of amplifier 409 is connected to inverting combiner node 526. There is no feedback impedance path between the inputs and outputs of amplifier 409, thereby providing circuit 401 with a higher gain-bandwidth while consuming less current.

In the embodiment shown, resistors 501-503 and 511-513 each have a resistance value equal to N*R, where R is the resistance value of resistor 507 and the resistance value of resistor 510. Because the resistors 501-503 connected to non inverting combiner node 525 have a "parallel" configuration and the resistors 511-513 connected inverting combiner node 526 have a "parallel" configuration, the total effective resistance from the input of DAC 407 to the output of DAC 407 (the connections to nodes 525 and 526) matches the effective resistance of filter 403 from its input (terminals 521 and 522) to its output (the connections to nodes 525 and 526).

Capacitors 504-506 and 514-516 each have a capacitance value equal to C/N, where C is the capacitance value of capacitor 508 and the capacitance value of capacitor 509. Because the capacitors 504-506 connected to non inverting combiner node 525 have a "parallel" configuration and the capacitors 514-516 connected to inverting combiner node 526 have a "parallel" configuration, the total effective capacitance from the input of DAC 407 to the output of DAC 407 (the connections to nodes 525 and 526) matches the effective capacitance of filter 403 from its input (terminals 521 and 522) to its output (the connections to nodes 525 and 526).

Because DAC 407 includes capacitors in capacitive paths from its input terminals to its output, the transfer function from the analog input to the combiner circuit is different than that for the circuit of Figure 3 in that the frequency-dependent attenuation of the transfer function is eliminated. For the circuit of Figure 5, the transfer function from the analog input to the combiner circuit is given as:

$$\text{EQ. 2} \quad TF(s) = 0.5\frac{1-05sRC}{1+sRC}VIN(s) - 0.5\frac{1+sRC}{1+sRC}VD1(s);$$

As shown above, because the effective capacitance of DAC 407 matches the effective capacitance of filter 403, the frequency components in the numerator and the denominator of the attenuation factor of DAC 407 ( $-0.5\frac{1+sRC}{1+sRC}$ ) are the same (1+sRC), and thus cancel out to where the remaining attenuation factor (-0.5) is frequency independent. Accordingly, the frequency dependent attenuation of circuit 401 is reduced which improves the frequency response of circuit 401 when compared to the circuit of Figure 3 that did not consider of the impact of DAC impedance loading. According, the residue generation configuration of the circuit of Figure 5 has a wider unity gain bandwidth than the configuration of Figure 3.

The elimination of DAC 407's frequency dependent attenuation factor provides the circuit with a flatter frequency profile that increases the effective bandwidth of ADC circuit 401 as well as DAC 407's sampled pulse response. This increases the effective number of bits (ENOB) of an ADC circuit as compared to other passive summation configurations.

In some simulations, a circuit having a configuration similar to the configuration of the embodiment of Figure 5 had a unity gain bandwidth of 12.8 GHz as compared to a unity gain bandwidth of 5.3 GHz for a circuit similar to that of Figure 3. Such simulations also indicate that the circuit similar to the circuit of Figure 5 obtained at least 1.5 times higher sampled pulse response from DAC 407 as compared to the sampled pulse response value from DAC 304 for the circuit similar to that of Figure 3, thereby indicating a larger gain.

In addition, the passive summation configuration of the circuit of Figure 5 provides for effective residual generation that consumes significantly less current than a transimpedance amplifier solution such as that of Figure 2 in that a passive summation configuration does not sink current through a feedback impedance path (e.g., impedances 221 and 223 of Figure 2).

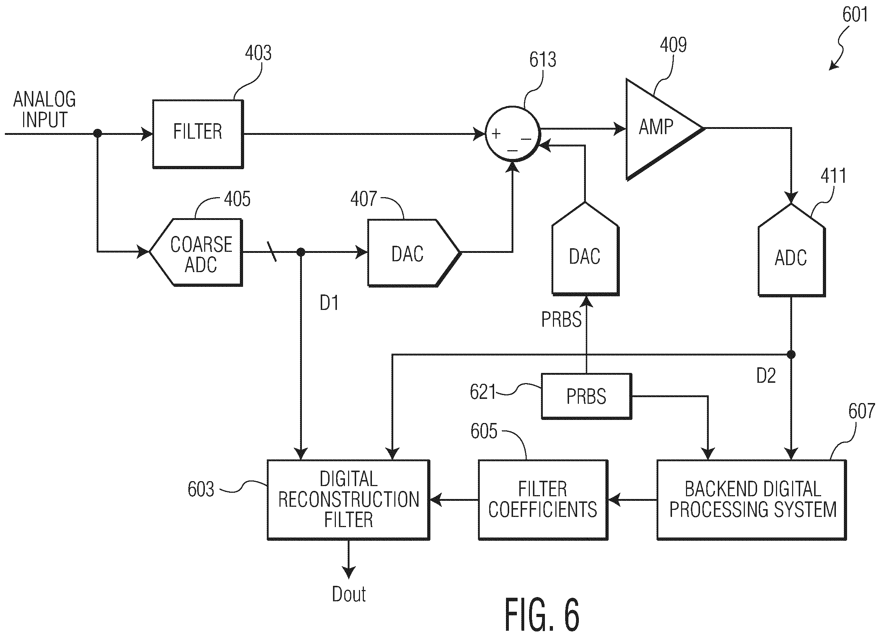

Figure 6 is a circuit diagram of an ADC circuit 601 according to another embodiment. The items with the same reference numbers as circuit 401 are similar. Circuit 601 differs from circuit 401 in that it includes the use of a dithering signal (PRBS) to set the filter coefficients 605 of a digital reconstruction filter 603 that generates a final digital output (DOUT) from digital signals D1 and D2.

In one embodiment, the PRBS signal is a digital pseudo random bit sequence generated by PRBS generator 621. The PRBS signal is injected into DAC 615, whose output is subtracted from the output of the filter 403 by combiner circuit 613. The output of combiner circuit 613 is provided to amplifier 409. In one embodiment, the configuration of DAC 615 is a replica of a unit element of DAC 407. ADC 411 provides a digital representation (D2) of the residue voltage generated at the output of amplifier 409. Reconstruction filter 603 utilizes residue signal D2 to adjust digital signal D1 to produce a final digital output DOUT such that the quantization error of the output of ADC 405 is minimized.

Circuit 601 includes a back end digital processing system 607. System 607 includes inputs to receive signal D2 from the output of ADC 411 and the PRBS sequence from generator 621. By comparing the two received signals, system 607 determines transfer function characteristics of DAC 615, combiner circuit 613, amplifier 409, and ADC 411. From the determined transfer function characteristics, system 607 adjusts the filter coefficients 605 of the digital reconstruction filter 603, which define how filter 603 adjusts signal D1 to produce DOUT based on residual signal D2.

In some embodiments, system 607 may be implemented with hardware, processor circuitry executing code or firmware, or a combination there of.

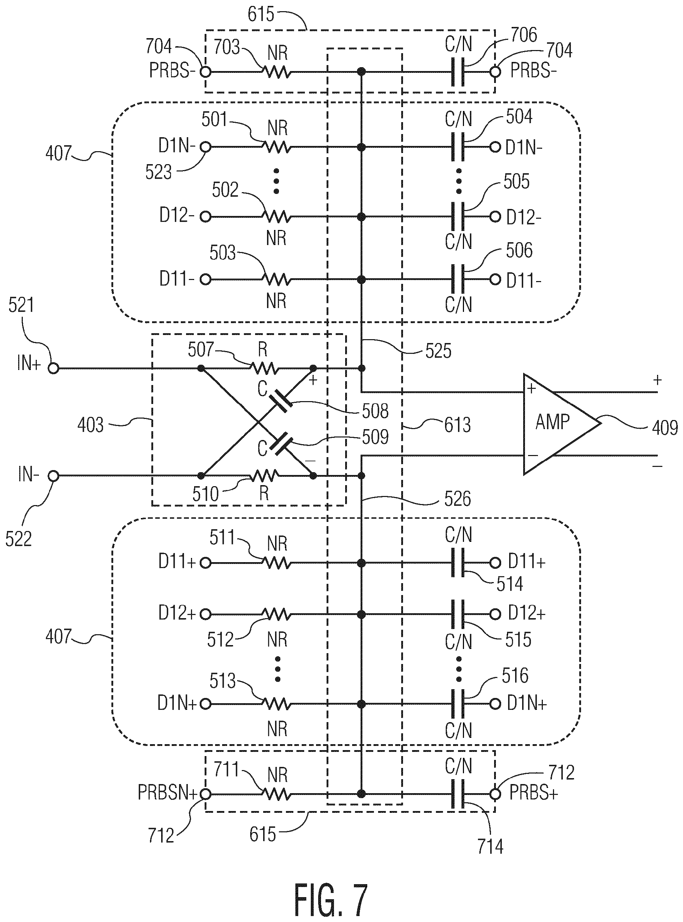

Figure 7 is a more detailed circuit diagram of the ADC circuit 601. Items with the same reference numbers as the items of Figure 5 are similar. In the embodiment of Figure 7, the PRBS signal is a differential signal that includes a non inverting signal bit component (PRBS+) that is provided to input terminal 712 and includes an inverting signal bit component (PRBS-) that is provided to input terminal 704. DAC 615 includes a resistor 703 in a resistance path from terminal 704 to non inverting node 525. DAC 615 includes a capacitor 706 in a capacitance path from terminal 704 to non inverting node 525. DAC 615 includes a resistor 711 in a resistance path from terminal 712 to inverting node 526. DAC 615 includes a capacitor 714 in a capacitance path from terminal 712 to non inverting node 526.

In one embodiment, the resistance of resistors 703 and 711 is N*R wherein R is the resistance value of resistors 507 and 510 and N is the number of digital signal components bits of the non inverting signal component of D1 (D11+ to D1N+) and of the inverting signal component of D1 (D11- to D1N-). The capacitance of capacitors 706 and 714 is C/N where C is the capacitance value of capacitor 508 and of capacitor 509. However, the capacitors and resistors may have other values in other embodiments. In one embodiment, the transfer function for the circuit configuration of Figure 7 is given by:

$$\text{EQ. 3} \quad TF(s) = \frac{N}{2N+1} \frac{1-sRC}{1+sRC} VIN(s) - \frac{N}{2N+1} VD1(s) - \frac{1}{2N+1} VPRBS(s);$$

As shown above in equation 3, the attenuation factor due to the PRBS signal ($-\frac{1}{2N+1}$) is not frequency dependent. Therefore, the unity gain bandwidth is larger, the delay profile is flatter, and the gain is higher than a passive summation configuration that does not include a capacitive path in the dithering DAC 615.

The ADC circuits of Figures 4 and 6 can be used in a number of applications where analog to digital conversion is needed. The circuits may be especially beneficial in high frequency applications with a wide bandwidth (e.g., 2 GHz or greater) and a relatively fast sampling time (e.g., 4 GHz or greater). In some embodiments, the circuit may provide an effective number of bits of 10, with a bandwidth of over 3 GHz, and a sampling rate of 10 GHz. However, other embodiments may provide a circuit with other operating parameters. Such ADC circuits may be used in communications systems and auto sensor systems. But embodiments of these circuits may be useful in other applications.

Modifications may be made to the embodiments shown and described herein. For example, although Figures 5 and 7 show ADC circuits configured to operate with differential signals, other embodiments may be configured to operate with single ended signals. Also, although the ADC circuits of Figures 4 and 6 are shown as single stage ADC circuits, ADC circuits with DACs having capacitors in capacitive paths as described herein may be implemented in multi-stage ADC circuits. In addition, filter 403 may have other configurations where multiple resistors may be included a resistive path and the resistors and capacitors may have different values. Also, the DACs (e.g., 407, 615) may have other configurations and/or include resistors and capacitors having different values. Furthermore, the combining circuits 413 and 613 may have other configurations as well.

Features described herein with respect to one embodiment may be implemented in other embodiments described herein. Two devices can be "coupled" to each other either through a current path with other devices or by being connected to each other. For example, referring to Figure 2, resistor R1 is coupled to resistor R3 through the current path that includes resistor R2. Resistor R1 is also coupled to the capacitor C2 by being connected to capacitor C2. Two characteristics are deemed to "match" where the two characteristics are designed to be effectively the same notwithstanding manufacturing related variances. Also as used herein, a capacitor in a capacitive path between two nodes or a resistor in resistive path between two nodes may include other devices in the path between the two nodes in addition to the capacitive path or the resistive path.

In one embodiment, an analog to digital converter (ADC) circuit includes: a circuit input configured to receive an analog signal; a filter circuit including an input coupled to the circuit input to receive the analog signal and an output to provide a filtered signal; a first ADC including an input coupled to the circuit input to receive the analog signal and including an output to provide a first digital signal that is a digital representation of the analog signal; a digital to analog converter (DAC) including an input coupled to receive the first digital signal and an output to provide an analog signal representative of the first digital signal, wherein the first digital signal is received by the DAC on at least one signal line from the first ADC; a combiner circuit that includes a first input coupled to the filter circuit to receive the filtered signal and a second input coupled to the output of the DAC to receive the analog signal from the DAC; wherein for each signal line of the at least one signal line on which the first digital signal is received, the DAC includes a resistive circuit located in a resistor path between a respective input terminal of the input of the DAC connected to the each signal line and the output of the DAC and includes a capacitor of a plurality of capacitors located in a capacitive path between the respective input terminal and output of the DAC.

In a further embodiment, the filter circuit includes at least one capacitor located between the input and the output of the filter circuit, wherein a total effective capacitance of the capacitors between the input and the output of the DAC matches to a total effective capacitance of the at least one capacitor between the input and output of the filter circuit.

In a further embodiment, the analog signal is a differential signal, the input of the filter circuit includes a first differential input terminal and a second differential input terminal to receive the analog signal; the output of the filter circuit includes a first differential output terminal and a second differential output terminal; the filter circuit includes a first capacitor located in a first path between the first differential input terminal and the second differential output terminal, and includes a second capacitor located in a path between the second differential input terminal and the first differential output terminal.

In a further embodiment, the first digital signal is a differential signal and includes a first differential digital signal component and a second differential digital signal component; the input of the DAC includes a first differential input of one or more first input terminals to receive the first differential digital signal component and includes a second differential input of one or more second input terminals to receive the second differential digital signal component; the output of the DAC includes a first differential output and a second differential output; the plurality of capacitors includes a first subset of one or more capacitors, each capacitor of the one or more capacitors of the first subset is located in a capacitor path between a respective first input terminal of the one or more first input terminals and the first differential output; the plurality of capacitors includes a second subset of one or more capacitors, each capacitor of the one or more capacitors of the second subset is located in a capacitor path between a respective second input terminal of the one or more second input terminals and the second differential output.

In a further embodiment, the combiner circuit includes a first differential node and a second differential node; each capacitor of the first subset of plurality of capacitors includes a terminal coupled to the first differential node; wherein each capacitor of the second subset of the plurality of capacitors includes a terminal coupled to the second differential node.

In a further embodiment, the ADC circuit further includes an amplifier including an input coupled to the combiner circuit, the amplifier including an output.

In a further embodiment, the amplifier is configured with the DAC, the filter circuit, and the combiner circuit in a passive summation configuration.

In a further embodiment, the ADC circuit further includes a second ADC including an input coupled to the output of the amplifier to provide a second digital signal which is a digital representation of the output of the amplifier.

In a further embodiment, the ADC circuit further includes: a second filter circuit having a first input to receive the first digital signal and a second input to receive the second digital signal, the second filter circuit having an output to produce a third digital signal that is digital representation of the analog signal based on the first digital signal and the second digital signal.

In a further embodiment, the ADC circuit further includes a second DAC including an input to receive a digital dither injection signal and an output to provide an analog representation of the digital dither injection signal to the combiner circuit, the second DAC includes at least one capacitor path including a capacitor and at least one resistive path including a resistive circuit between the input and the output of the second DAC.

In a further embodiment, the digital dither injection signal is a differential signal, wherein the input of the second DAC includes a first differential input and a second differential input and the output of the second DAC includes a first differential output and a second differential output; the at least one capacitor path of the second DAC includes a first capacitor path with a capacitor between the first differential input and the first differential output and includes a second capacitor path with a capacitor between the second differential input and the second differential output.

In a further embodiment, the first digital signal is a differential signal and includes a first differential digital signal component and a second differential digital signal component; the input of the DAC includes a first differential input of one or more first input terminals to receive the first differential digital signal component and includes a second differential input of one or more second input terminals to receive the second differential digital signal component; the output of the DAC includes a first differential output and a second differential output; the plurality of capacitors includes a first subset of one or more capacitors, each capacitor of the one or more capacitors of the first subset is located in a capacitor path between a respective first input terminal of the one or more first input terminals and the first differential output; the plurality of capacitors includes a second subset of one or more capacitors, each capacitor of the one or more capacitors of the second subset is located in a capacitor path between a respective second input terminal of the one or more second input terminals and the second differential output; wherein the capacitor of the first capacitor path of the second DAC matches the capacitance of each capacitor of the first subset of one of more capacitors of the DAC; wherein the capacitor of the second capacitor path of the second DAC matches the capacitance of each capacitor of the second subset of one of more capacitors of the DAC.

In a further embodiment, the combiner circuit includes a first differential node and a second differential node; the capacitor of the first capacitor path includes a terminal coupled to the first differential node and the capacitor of the second current path includes a terminal coupled to the second differential node.

In a further embodiment, the digital dither injection signal is characterized as a pseudo random digital signal.

In a further embodiment, the ADC circuit further includes: an amplifier including an input coupled to the combiner circuit, the amplifier including an output; a second ADC including and input coupled to the output of the amplifier to provide a second digital signal which is digital representation of the output of the amplifier; a second filter circuit having a first input to receive the first digital signal and a second input to receive the second digital signal, the second filter circuit having an output to provide a third digital signal that is a digital representation of the analog signal based on the first digital signal and the second digital signal as per a set of filter coefficients; a processing system that receives the digital dither injection signal and the second digital signal and adjusts at least one filter coefficient of the set of filter coefficients based on a comparison between the digital dither injection signal and the second digital signal.

In another embodiment, an analog to digital converter (ADC) circuit includes: a first circuit input terminal and a second circuit input terminal to receive an analog signal, wherein the analog signal is a differential signal and the first circuit input terminal and the second circuit input terminal are differential input terminals; a filter circuit including a first filter input terminal coupled to the first circuit input terminal and a second filter input terminal coupled to the second circuit input terminal, wherein the first filter input terminal and the second filter input terminal are differential terminals; a first ADC including an input to receive the analog signal and including an output to provide a first digital signal that is a digital representation of the analog signal, the first digital signal being a differential signal with a first differential signal component of one or more first component bits and a second differential signal component of one or more second component bits; a digital to analog converter (DAC) including a first set of one or more input terminals and a second set of one or more input terminals, wherein each input terminal of the first set is configured to receive a respective component bit of the one or more first component bits, and each input terminal of the second set is configured to receive a respective component bit of the one or more second component bits; a combiner circuit that includes a first combiner node and a second combiner node, where the first combiner node and the second combiner node are differential combiner nodes; wherein for each input terminal of the first set of one or more input terminals of the DAC, the DAC includes a resistive circuit located in a resistive path between the each input terminal and the first combiner node and includes a capacitor located in a capacitive path between the each input terminal and the first combiner node; wherein for each input terminal of the second set of one or more input terminals of the DAC, the DAC includes a resistive circuit located in a resistive path between the each input terminal and the second combiner node and includes a capacitor located in a capacitive path between the each input terminal and the second combiner node.

In a further embodiment, the ADC circuit further includes an amplifier including a first input terminal coupled to the first combiner node and a second input terminal coupled to the second combiner node, the first input terminal and the second input terminal being differential inputs.

In a further embodiment, there is no feedback path from an output of the amplifier to the input of the amplifier.

In a further embodiment, the ADC circuit further includes: a second DAC including a first input terminal and a second input terminal, the first input terminal and the second input terminal are differential input terminals; the first input terminal receiving a first differential component of a dither signal and the second input terminal receiving a second digital component of the dither signal; the second DAC including a first capacitor path including a first capacitor between the first input terminal of the second DAC and the first combiner node; the second DAC including a second capacitor path including a second capacitor between the second input terminal of the second DAC and the second combiner node.

In a further embodiment, the ADC circuit is characterized as a continuous timed pipelined ADC.

While particular embodiments of the present invention have been shown and described, it will be recognized to those skilled in the art that, based upon the teachings herein, further changes and modifications may be made without departing from the scope of this invention, as defined by the claims and there equivalents.

## Claims

1.   An analog to digital converter, ADC, circuit comprising:

a circuit input configured to receive an analog signal;
a filter circuit including an input coupled to the circuit input to receive the analog signal and an output to provide a filtered signal;
a first ADC including an input coupled to the circuit input to receive the analog signal and including an output to provide a first digital signal that is a digital representation of the analog signal;
a digital to analog converter, DAC, including an input coupled to receive the first digital signal and an output to provide an analog signal representative of the first digital signal, wherein the first digital signal is received by the DAC on at least one signal line from the first ADC;
a combiner circuit that includes a first input coupled to the filter circuit to receive the filtered signal and a second input coupled to the output of the DAC to receive the analog signal from the DAC;
wherein for each signal line of the at least one signal line on which the first digital signal is received, the DAC includes a resistive circuit located in a resistor path between a respective input terminal of the input of the DAC connected to the each signal line and the output of the DAC and includes a capacitor of a plurality of capacitors located in a capacitive path between the respective input terminal and output of the DAC.

**2.** The ADC circuit of claim 1 wherein the filter circuit includes at least one capacitor located between the input and the output of the filter circuit, wherein a total effective capacitance of the capacitors between the input and the output of the DAC matches to a total effective capacitance of the at least one capacitor between the input and output of the filter circuit.

**3.** The ADC circuit of claim 1 or 2 wherein:

the analog signal is a differential signal, the input of the filter circuit includes a first differential input terminal and a second differential input terminal to receive the analog signal;
the output of the filter circuit includes a first differential output terminal and a second differential output terminal;
the filter circuit includes a first capacitor located in a first path between the first differential input terminal and the second differential output terminal, and includes a second capacitor located in a path between the second differential input terminal and the first differential output terminal.

**4.** The ADC circuit of any preceding claim further wherein:

the first digital signal is a differential signal and includes a first differential digital signal component and a second differential digital signal component;
the input of the DAC includes a first differential input of one or more first input terminals to receive the first differential digital signal component and includes a second differential input of one or more second input terminals to receive the second differential digital signal component;
the output of the DAC includes a first differential output and a second differential output;
the plurality of capacitors includes a first subset of one or more capacitors, each capacitor of the one or more capacitors of the first subset is located in a capacitor path between a respective first input terminal of the one or more first input terminals and the first differential output;
the plurality of capacitors includes a second subset of one or more capacitors, each capacitor of the one or more capacitors of the second subset is located in a capacitor path between a respective second input terminal of the one or more second input terminals and the second differential output.

**5.** The ADC circuit of claim 4 wherein:

the combiner circuit includes a first differential node and a second differential node;
each capacitor of the first subset of plurality of capacitors includes a terminal coupled to the first differential node;
wherein each capacitor of the second subset of the plurality of capacitors includes a terminal coupled to the second differential node.

**6.** The ADC circuit of any preceding claim further comprising:
an amplifier including an input coupled to the combiner circuit, the amplifier including an output.

**7.** The ADC circuit of claim 6 wherein the amplifier is configured with the DAC, the filter circuit, and the combiner circuit in a passive summation configuration.

**8.** The ADC circuit of claim 6 or 7 further comprising:
a second ADC including an input coupled to the output of the amplifier to provide a second digital signal which is a digital representation of the output of the amplifier.

**9.** The ADC circuit of claim 8 further comprising:
a second filter circuit having a first input to receive the first digital signal and a second input to receive the second digital signal, the second filter circuit having an output to produce a third digital signal that is digital representation of the analog signal based on the first digital signal and the second digital signal.

**10.** The ADC circuit of any preceding claim further comprising:
a second DAC including an input to receive a digital dither injection signal and an output to provide an analog representation of the digital dither injection signal to the combiner circuit, the second DAC includes at least one capacitor path including a capacitor and at least one resistive path including a resistive circuit between the input and the output of the second DAC.

**11.** The ADC circuit of claim 10 wherein:

the digital dither injection signal is a differential signal, wherein the input of the second DAC includes a first differential input and a second differential input and the output of the second DAC includes a first differential output and a second differential output;

the at least one capacitor path of the second DAC includes a first capacitor path with a capacitor between the first differential input and the first differential output and includes a second capacitor path with a capacitor between the second differential input and the second differential output.

12. The ADC circuit of claim 11 further wherein:

the first digital signal is a differential signal and includes a first differential digital signal component and a second differential digital signal component;

the input of the DAC includes a first differential input of one or more first input terminals to receive the first differential digital signal component and includes a second differential input of one or more second input terminals to receive the second differential digital signal component;

the output of the DAC includes a first differential output and a second differential output;

the plurality of capacitors includes a first subset of one or more capacitors, each capacitor of the one or more capacitors of the first subset is located in a capacitor path between a respective first input terminal of the one or more first input terminals and the first differential output;

the plurality of capacitors includes a second subset of one or more capacitors, each capacitor of the one or more capacitors of the second subset is located in a capacitor path between a respective second input terminal of the one or more second input terminals and the second differential output;

wherein the capacitor of the first capacitor path of the second DAC matches the capacitance of each capacitor of the first subset of one of more capacitors of the DAC;

wherein the capacitor of the second capacitor path of the second DAC matches the capacitance of each capacitor of the second subset of one of more capacitors of the DAC.

13. The ADC circuit of claim 12 wherein:

the combiner circuit includes a first differential node and a second differential node;

the capacitor of the first capacitor path includes a terminal coupled to the first differential node and the capacitor of the second current path includes a terminal coupled to the second differential node.

14. The ADC circuit of any of claims 10 to 13 wherein the digital dither injection signal is characterized as a pseudo random digital signal.

15. The ADC circuit of any of claims 10 to 14 further comprising:

an amplifier including an input coupled to the combiner circuit, the amplifier including an output;

a second ADC including and input coupled to the output of the amplifier to provide a second digital signal which is digital representation of the output of the amplifier;

a second filter circuit having a first input to receive the first digital signal and a second input to receive the second digital signal, the second filter circuit having an output to provide a third digital signal that is a digital representation of the analog signal based on the first digital signal and the second digital signal as per a set of filter coefficients;

a processing system that receives the digital dither injection signal and the second digital signal and adjusts at least one filter coefficient of the set of filter coefficients based on a comparison between the digital dither injection signal and the second digital signal.

FIG. 1
PRIOR ART

FIG. 2
PRIOR ART

EP 4 701 086 A1

EP 4 701 086 A1

FIG. 3
PRIOR ART

FIG. 4

FIG. 5

FIG. 6

FIG. 7

Europäisches
Patentamt

European
Patent Office

Office européen
des brevets

# EUROPEAN SEARCH REPORT

**Application Number**

**EP 25 19 7332**

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | MANIVANNAN SARAVANA ET AL: "A 65-nm CMOS Continuous-Time Pipeline ADC Achieving 70-dB SNDR in 100-MHz Bandwidth", IEEE SOLID-STATE CIRCUITS LETTERS, IEEE, vol. 4, 8 April 2021 (2021-04-08), pages 92-95, XP011850725, DOI: 10.1109/LSSC.2021.3071965 [retrieved on 2021-04-16] * figures 1-2 * * pages 92-95 * | 1-15 | INV. H03M1/16 H03M1/80 |
| X | KUMAR CHAITANYA ET AL: "Power-Noise Trade-Offs in Continuous-Time Pipelined ADCs and Active Filters", IEEE TRANSACTIONS ON CIRCUITS AND SYSTEMS I: REGULAR PAPERS, IEEE, US, vol. 70, no. 10, 1 October 2023 (2023-10-01), pages 3832-3842, XP011950303, ISSN: 1549-8328, DOI: 10.1109/TCSI.2023.3302832 [retrieved on 2023-08-16] * figures 1-13 * * pages 3832-384 * | 1-15 | |
| X | PATIL SHARVIL ET AL: "22.2 A 700MHZ-BW -164dBFS/Hz-Small-Signal-NSD 703mW Continuous-Time Pipelined ADC with On-Chip Digital Reconstruction Achieving <-85dBFS HD3 using Digital Cancellation of DAC Errors", 2024 IEEE INTERNATIONAL SOLID-STATE CIRCUITS CONFERENCE (ISSCC), IEEE, vol. 67, 18 February 2024 (2024-02-18), pages 390-392, XP034562069, DOI: 10.1109/ISSCC49657.2024.10454477 [retrieved on 2024-03-13] * figure 22.2.2 * * page 390 * | 1-15 | **TECHNICAL FIELDS SEARCHED (IPC)**<br><br>H03M |

The present search report has been drawn up for all claims

| Place of search | Date of completion of the search | Examiner |
|---|---|---|
| The Hague | 9 January 2026 | Jespers, Michaël |

EPO FORM 1503 03.82 (P4C01)